# EUROPEAN PATENT APPLICATION

(11) **EP 2 224 487 A2**
(43) Date of publication of application: **01.09.2010**
(21) Application number: 10154616.6
(22) Date of filing: 25.02.2010
(51) Int. Cl.: H01L 27/146

(54) **Semiconductor optoelectronic device and quad flat non-leaded optoelectronic device**

(30) Priority: 25.02.2009 TW 98106002; 06.02.2010 TW 99103647
(71) Applicant: Everlight Electronics Co., Ltd., Tucheng City / Taipei County (TW)
(72) Inventor: Lai, Lu-Ming, Taiwan, ROC, Taipei (TW)
(74) Representative: Chamberlain, Alan James

(57) **Abstract**

A semiconductor optoelectronic device including a substrate, a control chip, a light-sensing chip and a molding compound is provided. The control chip is disposed on the substrate and electrically connected to the substrate. The light-sensing chip is disposed on the substrate and electrically connected to the substrate and the control chip. The molding compound encapsulates the control chip and a material of the molding compound is an insulating material doped with a non-electro-conductive magnetic conductive material.

## Description

### BACKGROUND OF THE INVENTION

### Field of the Invention

The present invention relates to a semiconductor optoelectronic device and a quad flat non-leaded optoelectronic device, and particularly relates to a semiconductor optoelectronic device and a quad flat non-leaded optoelectronic device capable of shielding electromagnetic interference.

### Description of Related Art

A conventional infrared receiver module(IRM) is fabricated by first packaging a semiconductor chip having an infrared sensing function and a control chip on a circuit substrate, and electrically connecting the semiconductor chip to the control chip so as to form the infrared receiver module. Conventionally, an iron housing is further added on the infrared receiver module to shield the electromagnetic interference (EMI). However, the extra step for adding the iron housing leads to the increasing of the dimension of the infrared receiver module and the cost for manufacturing the infrared receiver module. Moreover, it is not easy to design the iron housing and to assemble the iron housing onto the circuit substrate. Further, the iron housing is assembled onto the circuit substrate by the manual operation or the particular machine. Hence, the difficulty for assembling the iron housing onto the circuit substrate is increased and the yield of the assembling of the iron housing onto the circuit substrate is decreased.

In addition, the circuit substrate used in the infrared receiver module needs not only to satisfy high-temperature reflow requirements but also to comply with the "Restriction of the Use of Hazardous Substances in Electrical and Electronic Equipment Regulations ("RoHS Regulations" for short)" regulated by the European Union and the non-halogen environmental requirement. Thereby, the use of the circuit substrate is restrained.

Besides, in order to be compliant with the trend of miniaturization, it is necessary for the circuit substrate to be miniaturized. Moreover, semi-blind holes should also be formed on the circuit substrate, such that the infrared receiver module can receive the infrared light either when the infrared receiver module is placed horizontally (i.e., a infrared-sensing semiconductor chip faces up) or when the infrared receiver module is placed laterally (i.e., the infrared-sensing semiconductor chip faces left or right). Nonetheless, the circuit substrate having a compact size and the design of the semi-blind holes is formed with relatively high manufacturing costs. In addition, the metal layer remaining on the semi-blind holes should be often scraped off, which additionally increases labor costs.

The infrared receiver module having the infrared-sensing semiconductor chip can receive the infrared light either when the infrared receiver module is placed horizontally or when the infrared receiver module is placed laterally, given that the infrared-sensing semiconductor chip is disposed on a leadframe formed by bending exposed metal leads. However, the leadframe formed by bending the exposed metal leads has relatively large volume and great thickness, which is contrary to the current trend of miniaturization.

### SUMMARY OF THE INVENTION

The present invention provides a semiconductor optoelectronic device capable of shielding electromagnetic interference.

The present application is directed to a quad flat non-leaded optoelectronic device capable of reducing the manufacturing costs and having a relatively small package dimension.

The present invention provides a semiconductor optoelectronic device comprising a substrate, a control chip, a light-sensing chip and a first molding compound. The control chip is configured on the substrate and electrically connected to the substrate. The light-sensing chip is configured on the substrate and electrically connected to the control chip. The first molding compound encapsulates the control chip, and the first molding compound is made of an insulating material doped with a non-electro-conductive magnetic conductive material.

In one embodiment of the present invention, the non-electro-conductive magnetic conductive material comprises iron oxide.

In one embodiment of the present invention, the non-electro-conductive magnetic conductive material comprises Fe₃O₄, Sr-Fe₂O₄, maghemite (γ-Fe₂O₃), Mn_{0.5}Zn_{0.5}Fe₂O₄, Ni_{0.25}Cu_{0.25}Zn_{0.5}Fe₂O₄ or Mn_{0.5}Ni_{0.5}Fe₂O₄.

In one embodiment of the present invention, the substrate comprises a circuit substrate or a leadframe.

In one embodiment of the present invention, the leadframe comprises a die pad and a plurality of leads, and the control chip and the light-sensing chip are configured on the die pad and the leads are located around the die pad.

In one embodiment of the present invention, the semiconductor optoelectronic device further comprises a second molding compound encapsulating the control chip and the light-sensing chip, and the second molding compound is made of a transparent encapsulant.

In one embodiment of the present invention, the light-sensing chip comprises a photodiode or a phototransistor.

The present invention provides a quad flat non-leaded optoelectronic device comprising a leadframe, a control chip, a light-sensing chip, a first bonding wire, a plurality of second bonding wires, a first molding compound and a second molding compound. The leadframe has an upper surface and a lower surface opposite to the upper surface, and the leadframe comprises a plurality of leads. The control chip is configured on the upper surface of the leadframe. The light-sensing chip is configured on the upper surface of the leadframe. The first bonding wire connects the control chip and the light-sensing chip, such that the light-sensing chip and the control chip are electrically connected to each other. The second bonding wires connect the control chip and the leads, such that the control chip and the leads are electrically connected to each other. The first molding compound encapsulates the control chip, and the first molding compound is made of an insulating material doped with a non-electro-conductive magnetic conductive material. The second molding compound encapsulates a portion of the leadframe, the control chip, the light-sensing chip, the first bonding wire and the second bonding wires, and the second molding compound fills among the leads and the second molding compound is made of a transparent encapsulant.

In one embodiment of the present invention, the leadframe further comprises a die pad. The control chip and the light-sensing chip are configured on the die pad, and the leads are located around the die pad.

In one embodiment of the present invention, one of the leads and the die pad are integrally formed.

In one embodiment of the present invention, the second molding compound has at least one first positioning portion, and the first positioning portion is a recess or an opening.

In one embodiment of the present invention, the quad flat non-leaded optoelectronic device further comprises a metal conductive element configured on the lower surface of the leadframe. The second molding compound encapsulates a portion of the metal conductive element and exposes a surface of the metal conductive element relatively away from the leadframe.

In one embodiment of the present invention, the metal conductive element has a second positioning portion configured on the surface of the metal conductive element relatively away from the leadframe.

In one embodiment of the present invention, each of the leads has a recess located at an outer periphery of an end on a lower surface of the lead, and a shape of the recess is an arc.

In one embodiment of the present invention, the light-sensing chip is adapted to receive a light signal passing the second molding compound, and a wavelength of the light signal is about 770 nm∼1100 nm.

In one embodiment of the present invention, the light-sensing chip comprises a photodiode or a phototransistor.

In one embodiment of the present invention, the leads comprise an output lead and an input lead.

In one embodiment of the present invention, the second molding compound is adapted to absorb light in a waveband of visible light.

In one embodiment of the present invention, the non-electro-conductive magnetic conductive material comprises iron oxide.

In one embodiment of the present invention, the non-electro-conductive magnetic conductive material comprises Fe₃O₄, Sr-Fe₂O₄, maghemite (γ-Fe₂O₃), Mn_{0.5}Zn_{0.5}Fe₂O₄, Ni_{0.25}Cu_{0.25}Zn_{0.5}Fe₂O₄ or Mn_{0.5}Ni_{0.5}Fe₂O₄.

Accordingly, since the first molding compound of the present invention is doped with the non-electro-conductive magnetic conductive material, the first molding compound can conduct the magnetic field away from the control chip to achieve the electromagnetic interference shielding effect. Moreover, the light-sensing chip of the present invention is configured on a conductive leadframe and the second molding compound merely exposes the surface where the leads that are able to serve as external contact points. Therefore, the quad flat non-leaded optoelectronic device of the present invention can either be placed horizontally (i.e., the light-sensing chip faces up) or be placed laterally (i.e., the light-sensing chip faces left or right), such that the light-sensing chip receives the light signal passing the second molding compound. Further, because of the electrically conductive properties of the leadframe, the die pad can be directly grounded. As such, production efficiency of the optoelectronic device can be improved, while manufacturing costs and dimension of the optoelectronic device can be reduced.

In order to make the aforementioned and other features and advantages of the invention more comprehensible, embodiments accompanying figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

Fig. 1 is a schematic cross-sectional view of a semiconductor optoelectronic device according to one embodiment of the present invention.

Fig. 2A is a schematic top view of a quad flat non-leaded optoelectronic device according to one embodiment of the present invention.

Fig. 2B is a schematic bottom view of the quad flat non-leaded optoelectronic device depicted in Fig. 2A.

Fig. 2C is a schematic three-dimensional bottom view of the quad flat non-leaded optoelectronic device depicted in Fig. 2A.

### DESCRIPTION OF EMBODIMENTS

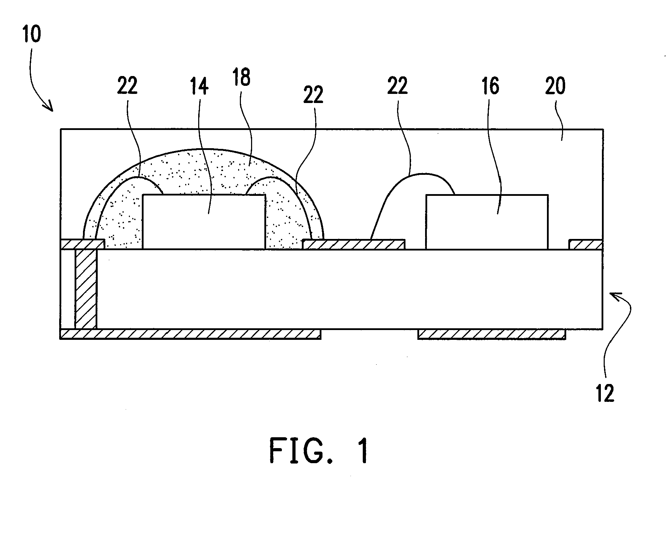

Fig. 1 is a schematic cross-sectional view of a semiconductor optoelectronic device according to one embodiment of the present invention. As shown in Fig. 1, a semiconductor optoelectronic device 10 comprises a substrate 12, a control chip 14, a light-sensing chip 16 and a first molding compound 18. In the present embodiment, the substrate 12 is a circuit substrate. The control chip 14 is configured on the substrate 12 and electrically connected to the substrate 12 through a plurality of bonding wires 22. The light-sensing chip 16 is configured on the substrate 12 and electrically connected to the substrate 12 and the control chip 14 through a plurality of bonding wires 22. In another embodiment, the control chip 14 and the light-sensing chip 16 can be optionally connected to the substrate 12 through the flip chip bonding technique.

The light-sensing chip 16 is adopted to receive a light signal and to convert the light signal to an electric signal. Further, the wavelength of the light signal is about 770 nm∼1100 nm. That is, the light-sensing chip 16 is adopted to receive the light signal in a waveband of infrared light. The control chip 14 has the functions of coding operation, decoding operation and/or logic operation. Further, the control chip 14 is adopted to receive and process the electrical signal from the light-sensing chip 16. More specifically, the light-sensing chip 16 can receive the light signal, convert the received light signal into an electric signal, and output the electric signal to the control chip 14 through the substrate 12. Then, the control chip 14 can code, decode, and/or perform a logic operation on the electric signal output by the light-sensing chip 16. In the present embodiment, the light-sensing chip 16 is, for example, a photodiode or a phototransistor.

The first molding compound 18 encapsulates the control chip 14 and the bonding wires 22. The first molding compound 18 is made of an insulating material and the insulating material is doped with a non-electro-conductive magnetic conductive material (not shown). The non-electro-conductive magnetic conductive material can be, for example, iron oxide. For instance, the non-electro-conductive magnetic conductive material comprises Fe₃O₄, Sr-Fe₂O₄, maghemite (γ-Fe₂O₃), Mn_{0.5}Zn_{0.5}Fe₂O₄, Ni_{0.25}Cu_{0.25}Zn_{0.5}Fe₂O₄, Mn_{0.5}Ni_{0.5}Fe₂O₄ or other non-electro-conductive materials with the magnetic conductivity. In the present embodiment, the diameter of the particle of the non-electro-conductive magnetic conductive material is about 1 micrometers.

It should be noticed that since the first molding compound 18 of the present embodiment is doped with the non-electro-conductive magnetic conductive material, the first molding compound 18 can conduct the magnetic field away from the control chip 14 to achieve the electromagnetic interference shielding effect. Accordingly, in the present embodiment, the first molding compound 18 can be formed on the control chip 14 only by dispensing, so that the first molding compound 18 can be used to replace the iron housing in the conventional technique. Thus, the process steps are simplified, the dimension of the semiconductor optoelectronic device 10 is decreased, the process yield is improved and the manufacturing cost is decreased. According to the above description, the first molding compound 18 of the present embodiment has the functions of shielding the electromagnetic interference and preventing the control chip 14 from being contaminated by the moisture and the pollutant from the external environment.

In the present embodiment, in order to prevent the light-sensing chip 16 and the control chip 14 from being contaminated by the external moisture or the impurities from the external environment, a second molding compound 20 can be formed on the substrate 12 to cover the light-sensing chip 16, the first molding compound 18 and the control chip 14. Furthermore, in order to allow the light-sensing chip 16 to receive the light signal passing the second molding compound 20, the second molding compound 20 is made of a transparent encapsulant. In other embodiments, the second molding compound 20 can only cover the light-sensing chip 16(not shown in the figures).

Embodiment in which the substrate is replced by a leadframe is described in detail hereinafter. It should be noticed that, in the present embodiment, a quad flat non-leaded optoelectronic device is used as an example. The present invention, however, is not limited thereto. Specifically, the semiconductor optoelectronic device of the present invention can be in any form of package structure, and the semiconductor optoelectronic device of the present invention is not limited to the package structure of the quad flat non-leaded optoelectronic device. Noticeably, in the following embodiment, the elements (e.g. the elements of the quad flat non-leaded optoelectronic device) which are named and labeled identically to those in Fig. 1, have the materials similar thereto. Therefore, the detailed descriptions are not repeated herein.

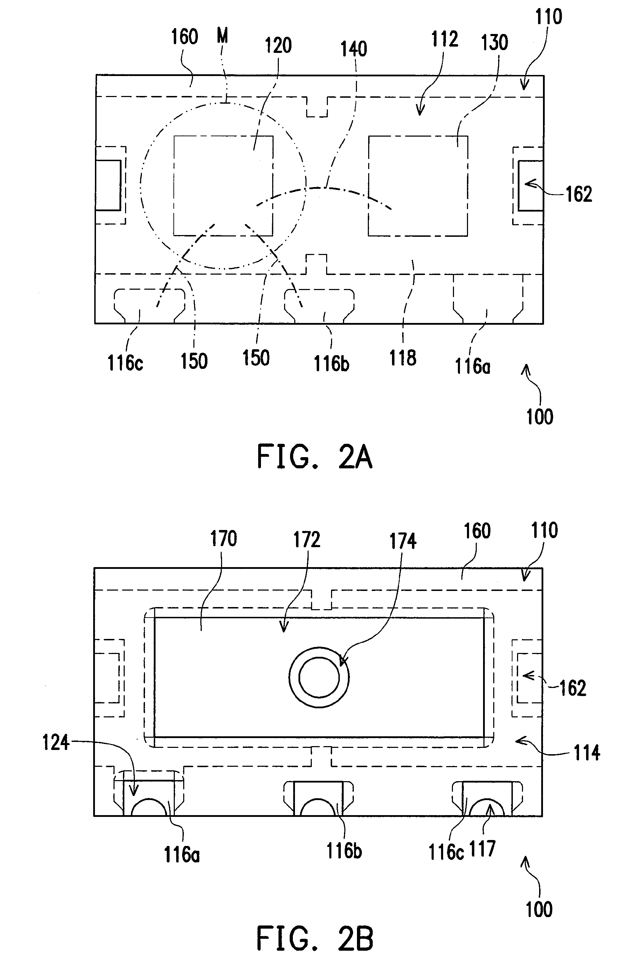

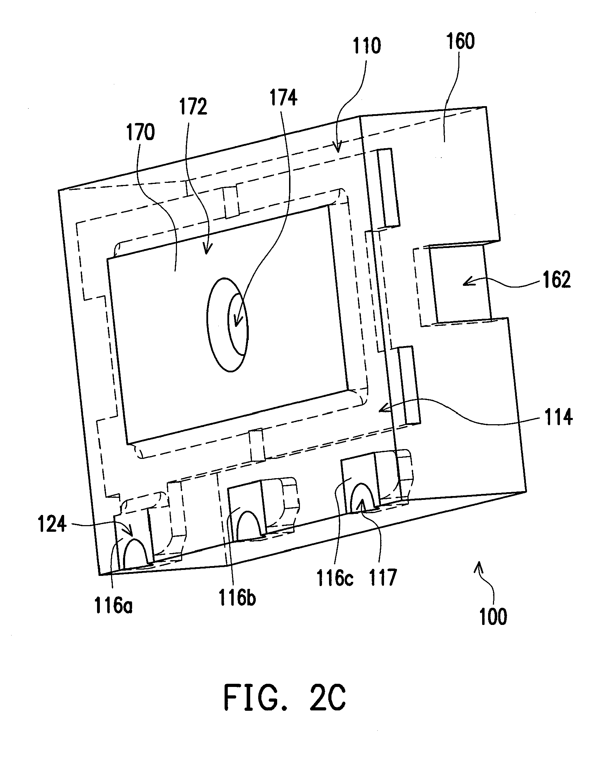

Fig. 2A is a schematic top view of a quad flat non-leaded optoelectronic device according to one embodiment of the present invention. Fig. 2B is a schematic bottom view of the quad flat non-leaded optoelectronic device depicted in Fig. 2A. Fig. 2C is a schematic three-dimensional bottom view of the quad flat non-leaded optoelectronic device depicted in Fig. 2A.

As shown in Figs. 2A, 2B and 2C, in the present embodiment, a quad flat non-leaded optoelectronic device 100 comprises a leadframe 110, a control chip 120, a light-sensing chip 130, a first bonding wire 140, a plurality of second bonding wires 150, a first molding compound M and a second molding compound 160.

More particularly, the leadframe 110 has an upper surface 112 and a lower surface 114 opposite to the upper surface 112. Besides, the leadframe 110 comprises a plurality of leads 116a∼116c and a die pad 118. The leads 116a∼116c are configured around the die pad 118, and each of the leads 116a∼116c has a recess 117 (for example: in an arc shape) located at an outer periphery of an end on a lower surface 124 of the leads 116a∼116c. The recess 117 in an arc shape can, for example, serve as an alignment mark. In the present embodiment, the leadframe 110 can be made of a metal conductive material, and the lead 116a and the die pad 118 are integrally formed. The lead 116a integrally formed with the die pad 118 can be regarded as a grounded lead.

The control chip 120 and the light-sensing chip 130 are configured on the upper surface 112 of the leadframe 110 and on the die pad 118. The first bonding wire 140 connects the control chip 120 and the light-sensing chip 130, such that the light-sensing chip 130 is electrically connected to the control chip 120 through the first bonding wire 140.

Two second bonding wires 150 respectively connect the control chip 120 and the lead 116b and connect the control chip 120 and the lead 116c, such that the control chip 120 is electrically connected to the leads 116b and 116c through the two second bonding wires 150. Also, the lead 116b is an output lead, while the lead 116c is an input lead. In general, the input lead is a power terminal which supplies the control chip 120 with electric energy for use. The output lead is a signal-outputting terminal. Through the output lead, the signal generated from coding, decoding, performing the logic operation on the light signal by the control chip 120 is output to external circuits which are electrically connected to the output lead.

It should be noticed that the types of the leads 116b and 116c are not limited in the present invention. The leads 116b and 116c discussed herein respectively refer to an output lead and an input lead respectively. However, the leads 116b and 116c in other embodiments can also be an input lead and an output lead, respectively, which is still a part of the technical proposal of the present application and is not departing from the scope of protection sought by the present application.

The first molding compound M encapsulates the control chip 120. It should be noticed that since the first molding compound M of the present embodiment is doped with the non-electro-conductive magnetic conductive material, the first molding compound M can conduct the magnetic field away from the control chip 120 to achieve the electromagnetic interference shielding effect.

The second molding compound 160 encapsulates a portion of the leadframe 110, the control chip 120, the light-sensing chip 130, the first molding compound M, the first bonding wire 140 and the two second bonding wires 150. In addition, the second molding compound 160 fills among the leads 116a∼116c. Further, the lower surface 124 of the leads 116a∼116c is exposed, and the lower surface 124 exposed can serve as electrical contact points for electrically connecting external apparatus. In the present embodiment, the second molding compound 160 blocks most of the light in a waveband of visible light (e.g., close to an infrared waveband) from entering the light-sensing chip 130, such that noises generated when the light-sensing chip 130 receives the light signal can be reduced. In addition, the second molding compound 160 has two first positioning portions 162 that are respectively located at side edges of the second molding compound 160 and serve as alignment marks. Further, the first positioning portions 162 are recesses or openings, for example.

In the present embodiment, the light-sensing chip 130 is configured on the leadframe 110 having electrically conductive properties, and the second molding compound 160 merely exposes the lower surface 124 of the leads 116a∼116c that can act as the external contact points. Due to the electrically conductive properties of the leadframe 110 in the quad flat non-leaded optoelectronic device 100 of the present embodiment, no matter the leadframe 110 is placed horizontally (i.e., the light-sensing chip 130 faces up) or laterally (i.e., the light-sensing chip 130 faces left or right), the light signal passing the second molding compound 160 can be received by the light-sensing chip 130. The light signal has a wavelength of about 770 nm∼1100 nm.

Additionally, the second molding compound 160 encapsulates a portion of the leadframe 110 and simply exposes the lower surface 124 of the leads 116a∼116c capable of serving as the external contact points. In comparison with the conventional infrared receiver module, the quad flat non-leaded optoelectronic device 100 of the present embodiment can be compliant with the requirement for miniaturization. Moreover, the leadframe 110 of the present embodiment has electrically conductive properties so that the die pad 118 can be directly grounded without being additionally conducted. Hence, the cost is decreased and the restrictions on the shape and the appearance of the optoelectronic device is reduced.

Furthermore, the quad flat non-leaded optoelectronic device 100 of the present embodiment further comprises a metal conductive element 170 configured on the lower surface 114 of the leadframe 110. The second molding compound 160 encapsulates a portion of the metal conductive element 170 and exposes a surface 172 of the metal conductive element 170 relatively away from the leadframe 110. More particularly, the metal conductive element 170 can be used as a heat dissipation element for dissipating thermal energy from the surface 172 which is not encapsulated by the molding compound 160. Here, the thermal energy is generated by the control chip 120 and the light-sensing chip 130. Alternatively, the metal conductive element 170 can be grounded, such that the surface 172 which is not encapsulated by the molding compound 160 can also be grounded directly.

Further, the metal conductive element 170 has a second positioning portion 174 configured on the surface 172 of the metal conductive element 170 relatively away from the leadframe 110. The second positioning portion 174 can serve as an alignment mark. When the quad flat non-leaded optoelectronic device 100 is electrically connected to other external apparatuses, not only can the second positioning portion 174 of the metal conductive element 170 be used in the alignment process, but also the first positioning portions 162 of the second molding compound 160 or the recesses 117 of the leads 116a∼116c can be used in the alignment process.

Accordingly, since the first molding compound is doped with the non-electro-conductive magnetic conductive material, the first molding compound can conduct the magnetic field away from the control chip to achieve the electromagnetic interference shielding effect. Thus, the first molding compound can be used to replace the iron housing in the conventional technique. The process steps are simplified, the dimension of the semiconductor optoelectronic device is decreased, the process yield is improved and the manufacturing cost is decreased.

Moreover, the light-sensing chip of the present application is configured on the leadframe having electrically conductive properties, and the second molding compound simply exposes the surface of the leads acting as the external contact points. Hence, the leadframe in the quad flat non-leaded optoelectronic device of the present application can be placed not only horizontally (i.e., the light-sensing chip faces up) but also laterally (i.e., the light-sensing chip faces left or right), such that the light-sensing chip can receive the light signal passing the second molding compound. In addition, because of the electrically conductive properties of the leadframe, the die pad can be directly grounded. Thus, the production efficiency of the optoelectronic device is improved, the manufacturing costs is decreased, and the dimension of the chip package structure is reduced.

Although the invention has been described with reference to the above embodiments, it will be apparent to one of the ordinary skill in the art that modifications to the described embodiment may be made without departing from the spirit of the invention. Accordingly, the scope of the invention will be defined by the attached claims not by the above detailed descriptions.

## Claims

1. A semiconductor optoelectronic device (10), comprising:
a substrate (12);
a control chip (14) configured on the substrate (12) and electrically connected to the substrate (12);
a light-sensing chip (16) configured on the substrate (12) and electrically connected to the control chip (14); and
a first molding compound (18) encapsulating the control chip (14), wherein the first molding compound (18) is made of an insulating material doped with a non-electro-conductive magnetic conductive material.

2. The semiconductor optoelectronic device (10) of claim 1, wherein the non-electro-conductive magnetic conductive material comprises iron oxide.

3. The semiconductor optoelectronic device (10) of claim 1, wherein the non-electro-conductive magnetic conductive material comprises Fe₃O₄, Sr-Fe₂O₄, maghemite (γ-Fe₂O₃), Mn_{0.5}Zn_{0.5}Fe₂O₄, Ni_{0.25}Cu_{0.25}Zn_{0.5}Fe₂O₄ or Mn_{0.5}Ni_{0.5}Fe₂O₄.

4. The semiconductor optoelectronic device (10) of claim 1, wherein the substrate (12) comprises a circuit substrate or a leadframe (110).

5. The semiconductor optoelectronic device (10) of claim 4, wherein the leadframe (110) comprises a die pad (118) and a plurality of leads (116a∼116c), and the control chip (14) and the light-sensing chip (16) are configured on the die pad (118) and the leads (116a∼116c) are located around the die pad (118).

6. The semiconductor optoelectronic device (10) of claim 1, further comprising:
a second molding compound (20) encapsulating the control chip (14) and the light-sensing chip (16), wherein the second molding compound (20) is made of a transparent encapsulant.

7. The semiconductor optoelectronic device (10) of claim 1, wherein the light-sensing chip (16) comprises a photodiode or a phototransistor.

8. A quad flat non-leaded optoelectronic device (100), comprising:
a leadframe (110) having an upper surface (112) and a lower surface (114) opposite to the upper surface (112), wherein the leadframe (110) comprises a plurality of leads (116a∼116c);
a control chip (120) configured on the upper surface (112) of the leadframe (110);
a light-sensing chip (130) configured on the upper surface (112) of the leadframe (110);
a first bonding wire (140) connecting the control chip (120) and the light-sensing chip (130), such that the light-sensing chip (130) is electrically connected to the control chip (120);
a plurality of second bonding wires (150) connecting the control chip (120) and the leads (116a∼116c), such that the control chip (120) is electrically connected to the leads (116a∼116c);
a first molding compound (M) encapsulating the control chip (120), wherein the first molding compound (M) is made of an insulating material doped with a non-electro-conductive magnetic conductive material; and
a second molding compound (160) encapsulating a portion of the leadframe (110), the control chip (120), the light-sensing chip (130), the first bonding wire (140), and the second bonding wires (150), wherein the second molding compound (160) fills among the leads (116a∼116c) and the second molding compound (160) is made of a transparent encapsulant.

9. The quad flat non-leaded optoelectronic device (100) of claim 8, wherein the leadframe (110) further comprises a die pad (118), and the control chip (120) and the light-sensing chip (130) are configured on the die pad (118) and the leads (116a∼116c) are located around the die pad (118).

10. The quad flat non-leaded optoelectronic device (100) of claim 9, wherein one of the leads (116a∼116c) and the die pad (118) are integrally formed.

11. The quad flat non-leaded optoelectronic device (100) of claim 8, wherein the second molding compound (160) has at least one first positioning portion (162), and the first positioning portion (162) is a recess (117) or an opening.

12. The quad flat non-leaded optoelectronic device (100) of claim 8, further comprising a metal conductive element (170) configured on the lower surface (114) of the leadframe (110), wherein the second molding compound (160) encapsulates a portion of the metal conductive element (170) and exposes a surface (172) of the metal conductive element (170) relatively away from the leadframe (110).

13. The quad flat non-leaded optoelectronic device (100) of claim 12, wherein the metal conductive element (170) has a second positioning portion (174) configured on the surface (172) of the metal conductive element (170) relatively away from the leadframe (110).

14. The quad flat non-leaded optoelectronic device (100) of claim 8, wherein each of the leads (116a∼116c) has a recess (117) located at an outer periphery of an end on a lower surface (114) of the lead, and a shape of the recess (117) is an arc.

15. The quad flat non-leaded optoelectronic device (100) of claim 8, wherein the light-sensing chip (130) is adapted to receive a light signal passing the second molding compound (160), and a wavelength of the light signal is about 770 nm∼1100 nm.

16. The quad flat non-leaded optoelectronic device (100) of claim 15, wherein the light-sensing chip (130) comprises a photodiode or a phototransistor.

17. The quad flat non-leaded optoelectronic device (100) of claim 8, wherein the leads (116a∼116c) comprise an output lead and an input lead.

18. The quad flat non-leaded optoelectronic device (100) of claim 8, wherein the second molding compound (160) is adopted to absorb light in a waveband of visible light.

19. The quad flat non-leaded optoelectronic device (100) of claim 8, wherein the non-electro-conductive magnetic conductive material comprises iron oxide.

20. The quad flat non-leaded optoelectronic device (100) of claim 8, wherein the non-electro-conductive magnetic conductive material comprises Fe₃O₄, Sr-Fe₂O₄, maghemite (γ-Fe₂O₃), Mn_{0.5}Zn_{0.5}Fe₂O₄, Ni_{0.25}Cu_{0.25}Zn_{0.5}Fe₂O₄ or Mn_{0.5}Ni_{0.5}Fe₂O₄.
